# EUROPÄISCHE PATENTSCHRIFT

(11) **EP 0 769 214 B1**
(45) Veröffentlichungstag und Bekanntmachung des Hinweises auf die Patenterteilung: **28.10.1998**
(21) Anmeldenummer: 95922417.1
(22) Anmeldetag: 27.06.1995
(51) Int. Cl.: H01R 4/04, H05K 13/04

(54) **VERFAHREN ZUR HERSTELLUNG EINER ELEKTRISCH LEITENDEN VERBINDUNG**
PROCESS FOR PRODUCING AN ELECTRICALLY CONDUCTIVE CONNECTION
PROCEDE DE REALISATION D'UNE CONNEXION ELECTRO-CONDUCTRICE

(30) Priorität: 14.07.1994 DE 4424831
(43) Veröffentlichungstag der Anmeldung: 23.04.1997
(73) Patentinhaber: ROBERT BOSCH GMBH, 70442 Stuttgart (DE)
(72) Erfinder: GRÜNWALD, Werner, D-70839 Gerlingen (DE); HAUG, Ralf, D-71229 Leonberg (DE); BURKHART, Thomas, D-66994 Dahn (DE); MENNIG, Martin, D-66287 Fischbach (DE); SCHMIDT, Helmut, D-66130 Saarbrücken (DE)
(86) Internationale Anmeldenummer: DE9500830
(87) Internationale Veröffentlichungsnummer: WO9602955

(56) Entgegenhaltungen:
- DE-A- 2 831 984
- DE-A- 3 810 285
- DE-A- 4 109 363

## Beschreibung

Die Erfindung betrifft ein Verfahren zur Herstellung einer elektrisch leitenden Verbindung nach dem Oberbegriff des Anspruchs 1.

### Stand der Technik

Es ist bekannt, elektrisch leitende Verbindungen zwischen zwei Elementen, wobei unter Elementen hier beispielsweise elektronische Bauteile, integrierte Schaltkreise, Leiterplatten oder ähnliches, die an der Oberfläche der Elemente herausgeführte, zu kontaktierende Kontaktbereiche aufweisen, verstanden werden, mittels eines elektrisch leitenden Schmelzklebers herzustellen. Die elektrisch leitenden Schmelzkleber besitzen in einem thermoplastischen Basismaterial dispergierte, elektrisch leitfähige Teilchen, die die elektrisch leitende Verbindung zwischen den Kontaktbereichen der zu verbindenden Elemente übernehmen. Die Kontaktbereiche werden hierbei unter Druck- und Wärmeeinwirkung unter Zwischenschaltung des Schmelzklebers zusammengefügt, so daß die elektrisch leitfähigen Teilchen mit den jeweiligen Kontaktbereichen kontaktieren, und so einen elektrisch leitenden Pfad ergeben. Beispielsweise wird in der DE-A-28 31 984 eine Verbindungsart zur elektrischen und mechanischen Verbindung zweier mit elektrischen Schaltkreisen versehener Träger oder zwischen einem solchen Träger und einer elektronischen Baugruppe mittels eines elektrisch leitenden Schmelzklebers beschrieben. Außerdem ist aus der DE-A-41 09 363 bekannt, Klebeverbindungen zwischen elektronischen Bauteilen und einem mit Schaltkreisen versehenen Substrat mittels eines elektrisch leitenden ersten Klebers, der die elektrischen Kontakte verbindet und mittels eines zweiten, elektrisch isolierenden Klebers, der zwischen einer Befestigungsfläche des Bauteiles und einer Montagefläche des Substrats angeordnet ist, zu realisieren. Bei den bekannten Verfahren ist nachteilig, daß die Schmelzkleber großflächig, das heißt, mehrere nebeneinander angeordnete Kontaktbereiche übergreifend, aufgebracht werden, so daß es bei der Kontaktierung der Elemente über die leitfähigen Teilchen in dem Schmelzkleber zu unerwünschten Kurzschlüssen zwischen benachbarten Kontaktbereichen kommen kann. Hierdurch sind Kontaktbereiche nur mit einer relativ geringen Auflösung, das heißt, einem relativ großen Abstand zueinander, elektrisch leitend verbindbar.

### Vorteile der Erfindung

Das erfindungsgemäße Verfahren mit den im Anspruch 1 angegebenen Merkmalen bietet demgegenüber den Vorteil, daß Kontaktbereiche mit einem relativ kleinen Abstand zueinander, das heißt mit großer Auflösung, sicher kontaktiert werden können, ohne daß zwischen nebeneinanderliegenden Kontaktbereichen Kurzschlüsse auftreten. Dadurch, daß der Schmelzkleber gezielt ausschließlich auf die Kontaktbereiche wenigstens eines der Elemente aufgebracht wird, ist es sehr vorteilhaft möglich, die Bereiche zwischen zwei benachbarten zu kontaktierenden Kontaktbereichen eines Elementes nicht mit dem Schmelzkleber zu benetzen. Somit können in diesen Bereichen die in dem Schmelzkleber dispergierten, elektrisch leitfähigen Teilchen keine Querverbindung zwischen den Kontaktbereichen herstellen.

In vorteilhafter Ausgestaltung der Erfindung ist vorgesehen, daß die Bereiche zwischen den Kontaktbereichen mit einer lyophoben Schicht versehen werden, so daß einerseits eine Benetzung dieser Bereiche während des Auftragens des Schmelzklebers auf die Kontaktbereiche durch Fließen des Schmelzklebers vermieden wird und andererseits während des Fügens der zwei Elemente der Schmelzkleber während seines Aufschmelzens diese Bereiche nicht benetzen kann. Unter lyophobe Schicht wird im Sinne der Erfindung allgemein eine flüssigkeitsabweisende beziehungsweise nicht mit Flüssigkeit benetzbare Schicht verstanden.

In weiterer vorteilhafter Ausgestaltung der Erfindung ist vorgesehen, daß der auf den Kontaktbereichen aufgebrachte Schmelzkleber derart plastisch strukturiert wird, daß sich Strukturen ergeben, die eine Selbstjustierung während des Fügens der Elemente ermöglichen. Somit wird ein Positionieraufwand zum lageorientierten Positionieren der zwei elektrisch leitend zu verbindenden Elemente verringert, da durch die Wahl der Strukturierung erreicht wird, daß die zu verbindenden Kontaktbereiche exakt gegenüberliegend zu liegen kommen.

Weitere vorteilhafte Ausgestaltungen der Erfindung ergeben sich aus den übrigen in den Unteransprüchen genannten Merkmalen.

### Zeichnung

Die Erfindung wird nachfolgend in Ausführungsbeispielen anhand der zugehörigen Zeichnungen näher erläutert. Es zeigen:
- Figur 1: eine Draufsicht und eine Seitenansicht eines mit Schmelzkleber versehenen Substrats;
- Figur 2: eine Verbindung von zwei Elementen;
- Figur 3: eine Einrichtung zum Aufbringen des Schmelzklebers;
- Figur 4: eine Verbindung zwischen zwei Elementen nach einem weiteren Ausführungsbeispiel und
- Figur 5: eine Verbindung zwischen zwei Elementen nach einem weiteren Ausführungsbeispiel.

### Beschreibung der Ausführungsbeispiele

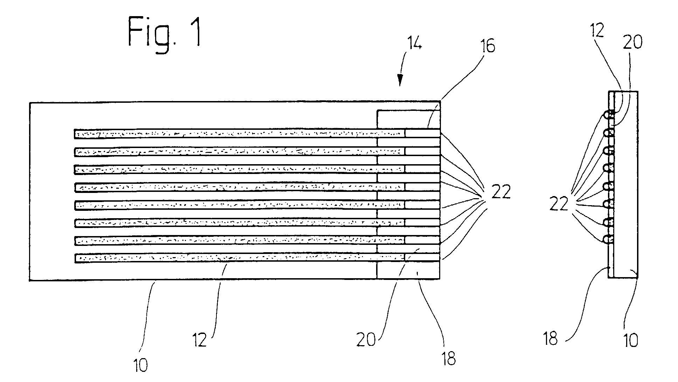

Figur 1 zeigt ein Substrat 10, das beispielsweise ein Keramiksubstrat sein kann. In beziehungsweise auf dem Keramiksubstrat 10 können, hier nicht dargestellte, elektronische Bauelemente angeordnet sein, deren Kontakte über Leiterbahnen 12 zu einem Anschlußbereich 14 des Substrats 10 geführt sind. In dem Anschlußbereich 14 weisen die Leiterbahnen 12 Kontaktbereiche 16 auf. Die Kontaktbereiche 16 werden hierbei von Abschnitten der Leiterbahnen 12 gebildet. Im Anschlußbereich 14 ist auf das Substrat 10 eine lyophobe Schicht 18 aufgebracht, die die Bereiche 20 zwischen zwei benachbarten Kontaktbereichen 16 sowie insgesamt den angrenzenden Anschlußbereichen 14 der Kontaktbereiche 16 überdeckt. Die Kontaktbereiche 16 selbst werden nicht mit der lyophoben Schicht 18 versehen. Auf die Kontaktbereiche 16 wird ein Schmelzkleber 22 aufgebracht, der in einem thermoplastischen Basismaterial dispergierte, elektrisch leitfähige Teilchen aufweist. Der Schmelzkleber 22 kann beispielsweise mittels einer Maske auf die Kontaktbereiche 16 mittels eines an sich bekannten Siebdruckverfahrens aufgedruckt werden. Die Maske weist hierzu eine dem Layout der Kontaktbereiche 16 entsprechende Maskierung auf. Zum Aufdrucken des Schmelzklebers 22 wird die Maske 24 mit ihrer Maskierung über den Kontaktbereichen 16 positioniert, so daß auf der Oberseite der Maske aufgebrachte, beispielsweise in Pastenform vorliegender Schmelzkleber durch die Maskierung durchtritt und somit gezielt auf die Kontaktbereiche 16 beschränkt auf dem Substrat 10 aufgebracht wird. Die Maske kann beispielsweise eine Metallmaske sein, deren Oberfläche mit einer lyophoben Beschichtung versehen ist. Hierdurch wird ein Verkleben beziehungsweise Vernetzen des Schmelzklebers mit der Maske verhindert. Die Maske kann selbstverständlich auch aus jedem anderen geeigneten Material bestehen.

In der in Figur 1 gezeigten stirnseitigen Ansicht des Substrats 10 wird deutlich, daß der Schmelzkleber 22 ausschließlich auf den Kontaktbereichen 16 der Leiterbahnen 12 aufgebracht ist. Die Bereiche 20 zwischen den Leiterbahnen 12 sind mit der lyophoben Schicht 18 aufgefüllt. Die lyophobe Schicht 18 kann beispielsweise aus einem fluoriertem Kunststoff bestehen.

Der Schmelzkleber 22 kann in an sich bekannter Weise auch photolithographisch auf die Kontaktbereiche 16 aufgebracht werden.

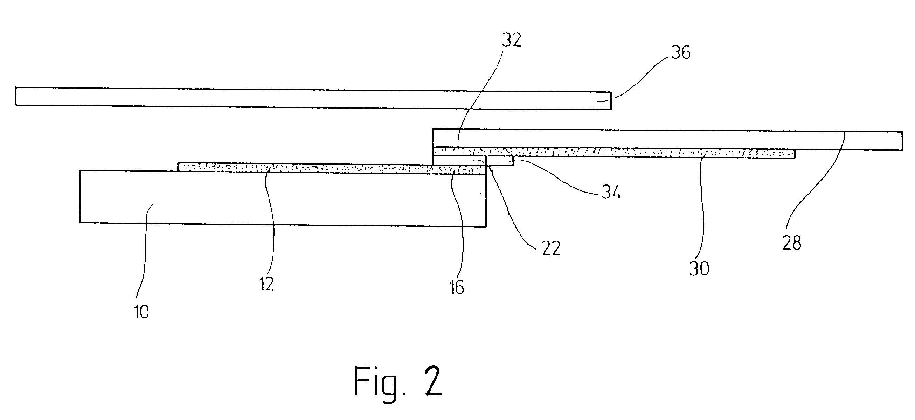

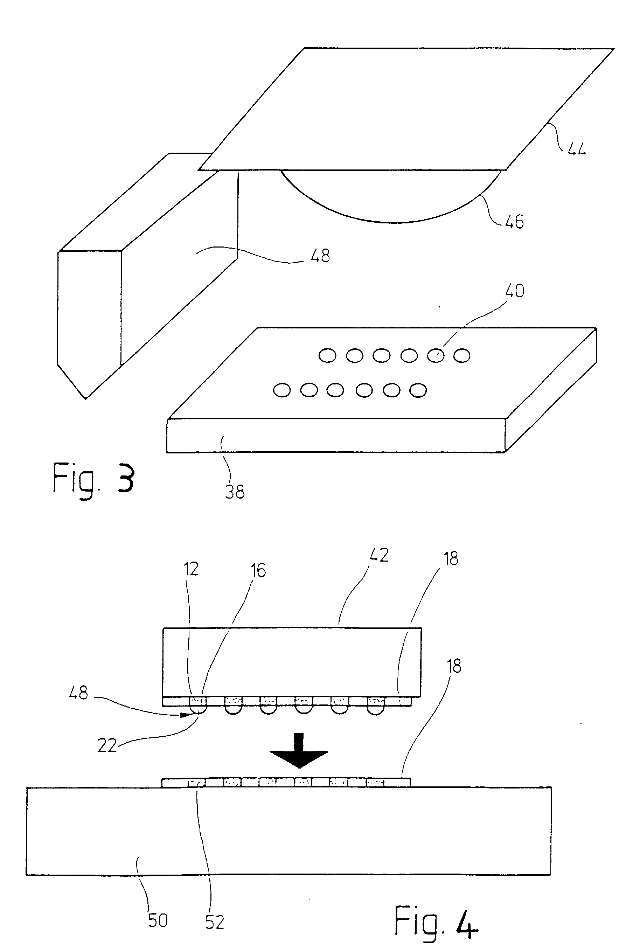

In der Figur 2 ist beispielhaft das Herstellen einer Fügeverbindung gezeigt. Das bereits in Figur 1 erläuterte Substrat 10 soll hier mit einem weiteren Substrat 28 elektrisch leitend verbunden werden. Das Substrat 28 kann beispielsweise eine flexible Anschlußfolie sein, über die auf dem Substrat 10 angeordnete elektronische Bauelemente mit anderen Einrichtungen, beispielsweise Verteilern, Anschlußsteckern oder ähnlichem verbunden werden sollen. Das Substrat 28 weist hierzu ebenfalls Leiterbahnen 30 auf, deren Kontaktbereiche 32 mit den Kontaktbereichen 16 der Leiterbahnen 12 kontaktiert werden sollen. Die Kontaktbereiche 16 beziehungsweise 32 sind dabei derart angeordnet, daß die zu kontaktierenden Bereiche sich gegenüberliegen. Das Substrat 28 wird nunmehr auf das Substrat 10 derart positioniert, daß die Kontaktbereiche 32 der Leiterbahn 30 auf den zuvor auf den Kontaktbereichen 16 der Leiterbahnen 12 aufgebrachten Schmelzkleber 22 zu liegen kommen. Hierzu kann beispielsweise eine in Figur 3 angedeutete Positionierhilfe 34, die als Anschlag ausgebildet ist, dienen. Die Positionierhilfe kann beispielsweise von einer zwischen die Leiterbahnen des Substrats 28 strukturierte lyophobe Schicht gebildet sein.

Die Substrate 10 und 28 werden unter Wärmeeinwirkung zusammengefügt. Als Wärmequelle dient hier beispielsweise eine Induktionseinrichtung 36. Diese weist einen von einem Strom durchflossenen elektrischen Leiter auf, dessen Magnetfeld in den Leiterbahnen 12 und 30 beziehungsweise deren Kontaktbereiche 16 und 32 eine Spannung induziert, die dort zu einem Stromfluß führt. über diesen Stromfluß werden die Kontaktbereiche 16 beziehungsweise 32 erwärmt, so daß der zwischen den Kontaktbereichen 16 und 32 angeordnete Schmelzkleber 22 über seine Schmelztemperatur hinaus erhitzt wird und somit dünnflüssig wird. Durch die Dünnflüssigkeit des Schmelzklebers 22 bilden die in diesem dispergierten elektrisch leitfähigen Teilchen einen elektrisch leitenden Pfad von jedem der Kontaktbereiche 16 zu jedem der Kontaktbereiche 32. Nach Abkühlen und Aushärten des Schmelzklebers 22 ist eine elektrisch leitende Verbindung zwischen den Leiterbahnen 12 und den Leiterbahnen 30 hergestellt, wobei das ausgehärtete Basismaterial des Schmelzklebers 22 gleichzeitig eine mechanische Ankopplung des Substrats 10 an das Substrat 28 gewährleistet. Insgesamt ist so durch ein einfaches Verfahren die Herstellung einer elektrisch leitenden Klebeverbindung zwischen den Substraten 10 und 28 möglich. Dadurch, daß die Bereiche 20 zwischen den Kontaktbereichen 16 mit einer lyophoben Schicht 18 versehen sind, ist eine sehr hohe Kontaktsicherheit gewährleistet. So kann der Schmelzkleber 22 während der Erhitzungsphase auf Temperaturen über dessen Schmelztemperatur die Bereiche 20 nicht benetzen, so daß eine elektrisch leitende Querverbindung zwischen benachbarten Leiterbahnen 12 beziehungsweise benachbarten Leiterbahnen 20 nicht möglich ist. Somit kann eine sehr hohe Auflösung bei den zu kontaktierenden Leiterbahnen 12 beziehungsweise 30 erreicht werden.

In den Figuren 3 und 4 ist ein weiteres Ausführungsbeispiel für die Herstellung einer elektrisch leitenden Verbindung gezeigt. Hierzu ist eine Klischeeplatte 38 vorgesehen, die an ihrer Oberfläche Vertiefungen 40 aufweist. Die Vertiefungen 40 sind dabei in einem bestimmten Raster angeordnet, das dem Anschlußraster eines zu kontaktierenden Bauteils 42 entspricht. Das Bauteil 42 kann beispielsweise ein integrierte elektronische Schaltungen aufweisender Chip sein, dessen nach außen geführte Anschlußbeinchen das Raster der Vertiefungen 40 vorgibt. Die Klischeeplatte 38 wird mit einem Schmelzkleber 22 beaufschlagt, beispielsweise durch Aufspritzen, Aufdrucken oder ähnlichem. Die Vertiefungen 40 sind zuvor mit einer lyophoben Schicht, beispielsweise aus fluoriertem Kunststoff versehen, so daß der Schmelzkleber 22 in den Vertiefungen 40 nicht ankleben kann.

Über die Klischeeplatte 38 wird ein hier angedeutetes Rakel 48 geführt, so daß die Oberfläche der Klischeeplatte 38 frei von Schmelzkleber ist und dieser ausschließlich in den Vertiefungen plan mit der Oberfläche der Klischeeplatte 38 vorhanden ist. Anschließend wird das Bauteil 42 über die Klischeeplatte 38 geführt, so daß die Anschlußkontakte des Bauteils 42 in die Vertiefungen 40 eingreifen können. Die Klischeeplatte 38 ist erhitzbar, so daß der Schmelzkleber in den Vertiefungen 40 aufschmilzt und die Anschlußkontakte des Bauteils 42 benetzen kann. Nach Abkühlen der Klischeeplatte 38 erstarrt der in den Vertiefungen 40 vorhandene Schmelzkleber und haftet an den Anschlußkontakten des Bauteils 42 an. Dieses kann nunmehr entnommen werden und ist gezielt, das heißt ausschließlich an seinen Anschlußkontakten mit Schmelzkleber versehen.

Eine weitere Möglichkeit des Aufbringens des Schmelzklebers 22 an den Anschlußkontakten des Bauteils 42 bietet der sogenannte Tampon-Druck. Hierbei wird in an sich bekannter Weise eine Einrichtung 44, die einen Tampon 46 aufweist, auf die Klischeeplatte 38 geführt. Der Tampon 46 besteht beispielsweise aus einem Silikongummi mit glatter Oberfläche. Die in den Vertiefungen 40 verbliebenen Bumps des Schmelzklebers 42 bleiben an dem Tampon 46 anhaften und können von diesem aus den Vertiefungen 40 ausgehoben werden. Die Bumps hängen dann, (in Figur 3 nicht dargestellt), an dem Tampon 46 und können an die Anschlußkontakte des Bauteils 42 überführt werden.

In der Figur 4 ist das mit dem Schmelzkleber 22 versehene Bauteil 42 dargestellt, wobei hier trotz des unterschiedlichen Aufbaus zur Verdeutlichung die gleichen Bezugszeichen wie in den Figuren 1 bis 3 verwendet sind. Das Bauteil 42 besitzt also die Kontakte 12, die gleichzeitig die Kontaktbereiche 16 bilden, zwischen denen die lyophobe Schicht 18 aufgebracht ist. Die Schicht 18 wird dabei vor dem in Figur 4 erläuterten Aufbringen des Schmelzklebers auf die Kontakte 12 aufgebracht. Die Kontakte 12 weisen die als Kontakt-Bumps 48 ausgebildeten Schmelzkleber 22 auf. Das Bauteil 42 kann nunmehr über einem Substrat 50 positioniert werden, wobei die Kontakte 12 mit hier vorgesehenen Leiterbahnen 52 kontaktiert werden sollen. Zwischen den Leiterbahnen 50 ist wiederum eine lyophobe Schicht 18 vorgesehen. Das Bauteil 42 wird unter Wärmeeinwirkung auf das Substrat 50 gefügt, so daß die Kontakte 12 über den Leiterbahnen 52 zu liegen kommen und eine elektrisch leitende Verbindung durch die in dem Schmelzkleber 22 dispergierten elektrisch leitfähigen Teilchen erfolgt. Die hier dargestellte Aufbringung der Kontakt-Pumps 48 an den Kontakten 12 ist lediglich beispielhaft. Hier ist selbstverständlich jedes andere geeignete Verfahren möglich.

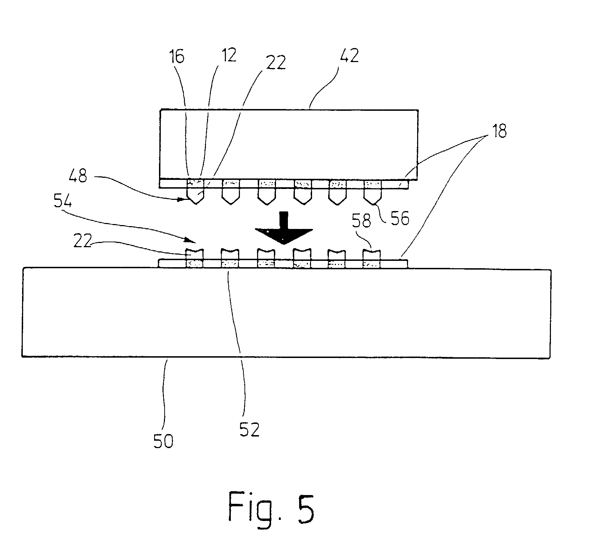

In der Figur 5 ist eine vorteilhafte Ausgestaltung der Erfindung dargestellt. Hierbei sind sowohl auf die Kontaktbereiche 16 des Bauteils 42 und die Leiterbahnen 52 des Substrats 50 Schmelzkleber 22 aufgebracht. Die Kontaktbereiche 16 weisen hierbei die bereits in den Figuren 3 und 4 erläuterten Kontakt-Bumps 48 auf. Auf den Kontaktbereichen der Leiterbahnen 52 sind ebenfalls Kontakt-Bumps 54 angeordnet. Die Kontakt-Bumps 48 und 54 sind plastisch verformt. Die Kontakt-Bumps 48 weisen eine in etwa kegelförmig verlaufende Spitze 56 auf, während die Kontakt-Bumps 54 eine der Spitze 56 entsprechend angepaßte kegelförmige Vertiefung 58 besitzen. Die Vertiefungen 58 bilden somit eine Negativform der Spitzen 56 aus. Die plastischen Verformung der Kontakt-Bumps 48 beziehungsweise 54 kann dabei durch geeignete Werkzeuge erfolgen, die entsprechende, gegebenenfalls beheizbare Stempel aufweisen. Durch die plastische Verformung der Kontakt-Bumps 48 beziehungsweise 54 ist eine Positionierung der zu verbindenden Elemente, hier des Bauteils 42 und des Substrats 50, einfacher möglich. Während des Fügens des Bauteils 42 auf das Substrat 50 findet quasi eine Selbstjustierung zwischen den Kontaktbereichen 16 und den Leiterbahnen 52 statt, so daß diese genau gegenüberliegend angeordnet sind. Das Herstellen der elektrisch leitenden Verbindung erfolgt durch Erwärmen des Schmelzklebers 22 über dessen Schmelztemperatur, so daß die elektrisch leitfähigen Teilchen in dem Schmelzkleber 22 sich zu einem elektrisch leitenden Pfad zwischen den Kontaktbereichen 16 und den Leiterbahnen 52 verbinden. Das Basismaterial des Schmelzklebers 52 gewährleistet nach Abkühlung und entsprechender Aushärtung die mechanische Haftung des Bauteils 42 an dem Substrat 50.

## Patentansprüche

1. Verfahren zur Herstellung einer elektrisch leitenden Verbindung zwischen gegenüberliegenden Kontaktbereichen von zwei zu verbindenden Elementen mittels eines in einem thermoplastischen Basismaterial dispergierten, elektrisch leitfähige Teilchen aufweisenden Schmelzklebers, wobei der Schmelzkleber auf die Kontaktbereiche wenigstens einer der Elemente aufgebracht wird und diese anschließend unter Wärmeeinwirkung gefügt werden, **dadurch gekennzeichnet**, daß im Raster der Kontaktbereiche auf einer Klischeeplatte (38) vorgesehene Vertiefungen (40) mit dem Schmelzkleber (22) gefüllt werden, die Kontaktbereiche mit den mit Schmelzkleber (22) gefüllten Vertiefungen (40) in Berührungskontakt gebracht werden, das mit den an den Kontaktbereichen anhaftenden Schmelzkleber versehene Element anschließend der Klischeeplatte (38) entnommen und mit dem weiteren Element gefügt wird.

2. Verfahren nach Anspruch 1, **dadurch gekennzeichnet,** daß die in den Vertiefungen (40) erzeugten Kontakt-Bumps (48) aus Schmelzkleber (22) thermisch an die Kontaktbereiche (16) angekoppelt werden.

3. Verfahren nach einem der vorhergehenden Ansprüche, **dadurch gekennzeichnet,** daß der Schmelzkleber (22) bündig mit der Oberfläche der Klischeeplatte (38) in die Vertiefungen (40) eingebracht wird.

4. Verfahren nach einem der vorhergehenden Ansprüche, **dadurch gekennzeichnet,** daß über die Oberfläche der Klischeeplatte (38) überstehender Schmelzkleber (22) mit einem Rakel (47) abgezogen wird.

5. Verfahren nach einem der vorhergehenden Ansprüche, **dadurch gekennzeichnet**, daß die Vertiefungen (40) vor Einbringen des Schmelzkleber (22) mit einer lyophoben Schicht versehen werden.

6. Verfahren nach Anspruch 1, **dadurch gekennzeichnet**, daß die in den Vertiefungen (40) erzeugten Kontakt-Bumps (48) aus Schmelzkleber (22) mittels eines Tampon-Druckverfahrens an die Kontaktbereiche (16) angekoppelt werden.

7. Verfahren nach einem der vorhergehenden Ansprüche, **dadurch gekennzeichnet**, daß auf den zu verbindenden Kontaktbereichen (16) gegenüberliegend aufgebrachte Schmelzkleber (22) derart strukturiert werden, daß sich eine Selbstjustierung während des Fügens der Elemente (10,28,42,50) ergibt.

## Claims

1. Method of producing an electrically conducting joint between oppositely situated contact regions of two elements to be joined by means of a hot melt adhesive containing electrically conductive particles dispersed in a thermoplastic base material, the hot melt adhesive being applied to the contact regions of at least one of the elements and said elements then being joined by exposure to heat, characterized in that recesses (40) provided in the pattern of the contact regions on a printing block (38) are filled with the hot melt adhesive (22), the contact regions are brought into contiguous contact with the recesses (40) filled with hot melt adhesive (22), the element provided with the hot melt adhesive adhering to the contact regions is then removed from the printing plate (38) and is joined to the further element.

2. Method according to Claim 1, characterized in that the contact bumps (48) made of hot melt adhesive (22) produced in the recesses (40) are thermally coupled to the contact regions (16).

3. Method according to one of the preceding claims, characterized in that the hot melt adhesive (22) is introduced into the recesses (40) flushly with the surface of the printing plate (38).

4. Method according to one of the preceding claims, characterized in that hot melt adhesive (22) projecting above the surface of the printing plate (38) is drawn off with a doctor blade (47).

5. Method according to one of the preceding claims, characterized in that the recesses (40) are provided with a lyophobic layer before the hot melt adhesive (22) is introduced.

6. Method according to Claim 1, characterized in that the contact bumps (48) made of hot melt adhesive (22) produced in the recesses (40) are coupled by means of a tampon pressure method to the contact regions (16).

7. Method according to one of the preceding claims, characterized in that hot melt adhesives (22) oppositely applied to the contact regions (16) to be joined are structured in such a way that a self-alignment arises during the joining of the elements (10, 28, 42, 58).

## Revendications

1. Procédé de réalisation d'une connexion électrique entre deux zones de contact en regard de deux éléments à réunir à l'aide d'une colle thermofusible contenant des particules conductrices électriques dispersées dans une matière de base thermoplastique,
la colle thermofusible étant appliquée sur des zones de contact d'au moins l'un des éléments et ceux-ci étant réunis alors par action thermique,
caractérisé en ce qu'
- on remplit avec de la colle thermofusible (22) les cavités (40) d'une trame des plages de contact d'une plaque de photogravure (38),
- on met en contact mécanique les plages de contact avec les cavités (40) remplies de colle fusible (22) de façon à être prises avec l'élément muni de colle fusible accroché aux plages de contact de façon adjacente à la plaque (38) et être réunies à un autre élément.

2. Procédé selon la revendication 1,
caractérisé en ce que
les bossages de contact (48), réalisés dans les cavités (40) en colle thermofusible (22), sont couplés aux zones de contact (16).

3. Procédé selon l'une des revendications précédentes,
caractérisé en ce que
la colle fusible (22) est mise dans les cavités (40) de manière à être à fleur avec la surface supérieure de la plaque (38).

4. Procédé selon l'une des revendications précédentes,
caractérisé en ce que
la colle fusible (22), qui dépasse de la surface de la plaque (38), est enlevée avec un racloir (47).

5. Procédé selon l'une des revendications précédentes,
caractérisé en ce que
les cavités (40) sont munies d'une couche lyophobe avant l'introduction de la colle fusible (22).

6. Procédé selon la revendication 1,
caractérisé en ce que
les bossages de contact (48), réalisés dans les cavités (40) en colle fusible (22), sont couplés aux zones de contact (16) par un procédé d'impression par tampon.

7. Procédé selon l'une quelconque des revendications précédentes,
caractérisé en ce que
sur la colle fusible (22) appliquée en regard des zones de contact (16) à relier, on réalise une structure assurant un auto-ajustage pendant la réunion des éléments (10, 28, 42, 50).
